# FASCICULE DE BREVET EUROPEEN

(11) **EP 2 429 027 B1**
(45) Date de publication et mention de la délivrance du brevet: **21.11.2012**
(21) Numéro de dépôt: 11180021.5
(22) Date de dépôt: 05.09.2011
(51) Int. Cl.: H01P 5/18

(54) **Coupleur en boîtier**
In einem Gehäuse angeordneter Koppler
Coupler within a housing

(30) Priorité: 10.09.2010 FR 1057191
(43) Date de publication de la demande: 14.03.2012
(73) Titulaire: STMicroelectronics (Tours) SAS, 37100 Tours (FR)
(72) Inventeur: Ezzeddine, Hilal, 37100 Tours (FR); Laporte, Claire, 37000 Tours (FR)
(74) Mandataire: de Beaumont, Michel

(56) Documents cités:
- US-A1- 2009 231 057
- US-B1- 6 542 375

## Description

### Domaine de l'invention

La présente invention concerne de façon générale l'industrie électronique et, plus particulièrement, les systèmes d'émission-réception radiofréquence. L'invention concerne, plus particulièrement, la réalisation d'un coupleur dans un boîtier.

### Exposé de l'art antérieur

Un coupleur est généralement utilisé pour prélever une partie de la puissance présente sur une ligne de transmission, dite principale ou primaire, vers une autre ligne, dite couplée ou secondaire, située à proximité. Les coupleurs se répartissent en deux catégories selon qu'ils sont constitués de composants passifs discrets (on parle alors de coupleur à éléments localisés) ou de lignes conductrices proches les unes des autres pour être couplées (on parle alors de coupleur en lignes distribuées). L'invention concerne la deuxième catégorie de coupleurs. Les ports de la ligne principale sont généralement désignés IN (entrée) et OUT (sortie). Ceux de la ligne couplée sont généralement désignés CPL (couplé) côté borne IN et ISO (isolé) côté borne OUT.

Les coupleurs en lignes distribuées sont généralement réalisés sous la forme de lignes conductrices sur un substrat mince isolant. Des éléments résistifs formant des atténuateurs peuvent également être intégrés avec le coupleur. Une fois terminé, l'ensemble est encapsulé dans un boîtier pourvu, par exemple, de bossages conducteurs (bumps) de raccordement sur une carte de circuits électroniques.

Lors de leur réalisation sur le substrat, les lignes conductrices du coupleur sont généralement entourées d'un plan de masse.

Les inventeurs se sont aperçus que ce plan de masse avait un impact sur les performances du coupleur et notamment sur sa directivité, qui représente la différence de pertes en transmission entre les ports ISO et CPL, depuis le port IN. Par ailleurs, la taille des bossages conducteurs a également une influence sur ces performances. Plus les bossages sont importants, plus la directivité est dégradée.

Le document US 6 542 375 B1 décrit un coupleur comme défini dans le préambule de la revendication 1.

### Résumé

Un objet d'un mode de réalisation de la présente invention est de proposer un coupleur qui pallie tout ou partie des inconvénients des coupleurs usuels.

Un autre objet d'un mode de réalisation de la présente invention est de proposer un coupleur de faible encombrement.

Un autre objet d'un mode de réalisation de la présente invention est d'éviter la dégradation de la directivité d'un coupleur sous l'effet d'un plan de masse.

Pour atteindre tout ou partie de ces objets ainsi que d'autres, on prévoit un coupleur en lignes distribuées comportant une première ligne destinée à véhiculer un signal radiofréquence entre ses deux extrémités et une deuxième ligne destinée à prélever, par couplage, une partie dudit signal, dans lequel :
une des lignes est formée sur un substrat isolant ; et
l'autre ligne est formée dans une grille de connexion sur laquelle est rapporté le substrat, les deux lignes étant à l'aplomb l'une de l'autre.

Selon un mode de réalisation de la présente invention, les extrémités de la deuxième ligne sont connectées à des atténuateurs résistifs.

Selon un mode de réalisation de la présente invention, des plans de masse sont réalisés approximativement à l'aplomb l'un de l'autre sur le substrat et dans la grille de connexion.

Selon un mode de réalisation de la présente invention, la deuxième ligne est réalisée sur une première face du substrat, rapporté par son autre face à l'aplomb de la ligne principale.

Selon un mode de réalisation de la présente invention, la deuxième ligne est formée sur la première face du substrat, rapportée par l'intermédiaire de bossages conducteurs sur la grille de connexion.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une représentation schématique d'un coupleur en lignes distribuées ;
la figure 2 est une vue de dessus schématique d'un niveau conducteur rapporté sur un substrat dans un coupleur usuel ;
la figure 3 est une représentation schématique d'un mode de réalisation d'un coupleur ;
la figure 4 représente un mode de réalisation d'une partie du coupleur de la figure 3 ;
la figure 5 est une vue de dessous du boîtier du coupleur de la figure 3 ;
la figure 6 représente une vue en coupe d'un mode de réalisation d'un coupleur en boîtier ; et
la figure 7 représente une vue en coupe d'un autre mode de réalisation d'un coupleur en boîtier.

### Description détaillée

De mêmes éléments ont été désignés par de mêmes références aux différentes figures qui ont été tracées sans respect d'échelle. Par souci de clarté, seuls les éléments utiles à la compréhension de l'invention ont été représentés et seront décrits. En particulier, les différents circuits amont et aval susceptibles d'être connectés au coupleur n'ont pas été détaillés, l'invention étant compatible avec les utilisations usuelles d'un coupleur dans des chaînes d'émission-réception radiofréquence. De plus, les étapes de fabrication proprement dites du coupleur n'ont pas été détaillées, l'invention étant là encore compatible avec les étapes usuelles.

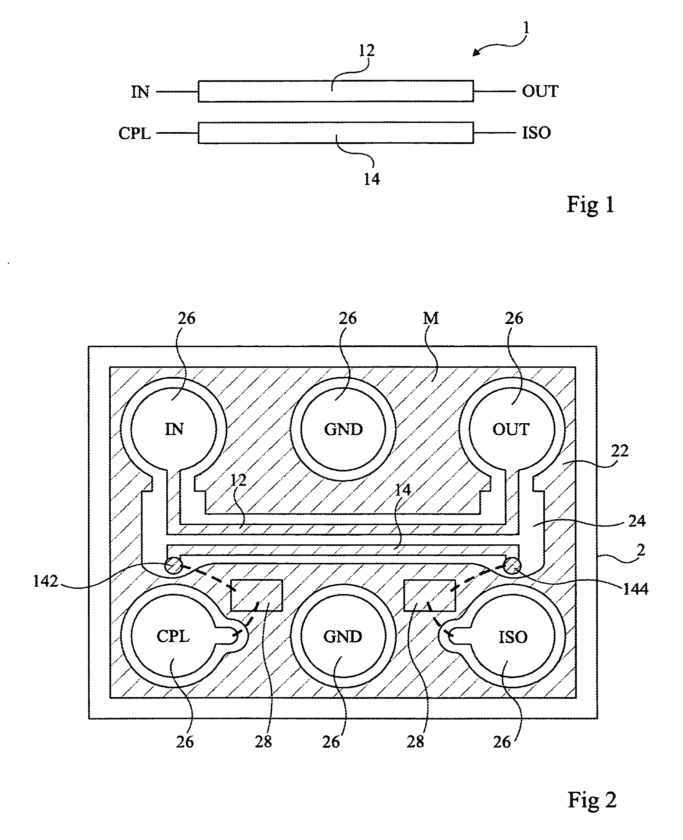

La figure 1 représente schématiquement un coupleur 1 en lignes distribuées. Le coupleur comporte une ligne principale 12 destinée à véhiculer un signal radiofréquence (reçu ou émis). Un port ou accès IN, dit d'entrée, est côté réception du signal (côté amplificateur ou côté antenne selon le sens de transmission) tandis qu'un port ou accès OUT (parfois également appelé DIR), dit de sortie, est à l'inverse côté antenne ou côté amplificateur de réception. Une ligne couplée ou secondaire 14 du coupleur 1 prélève une partie de la puissance de la ligne principale. Un port CPL du coupleur correspond à l'extrémité de la ligne secondaire côté port IN et fournit une information sur la mesure. L'autre extrémité de la ligne définit un port ISO.

Dans l'exemple de la figure 1, le coupleur est symétrique, c'est-à-dire que la définition de ses ports ou accès dépend des connexions externes.

La figure 2 est une vue de dessus schématique d'un coupleur réalisé sur un substrat isolant 2 par des dépôts en couche mince.

Plusieurs niveaux conducteurs (dont un seul 22 est représenté en figure 2) sont superposés avec interposition de niveaux isolants sur le substrat 2. Un plan de masse M est réalisé dans le niveau conducteur 22 et les lignes principale 12 et secondaire 14 sont réalisées sous la forme de pistes conductrices dans une ouverture 24 du plan de masse. Les ports IN, OUT, CPL et ISO sont ramenés sur des zones 26 de réalisation de bossages conducteurs. Le cas échéant, les extrémités 142 et 144 de la ligne secondaire ne sont pas directement reliées aux plots 26 correspondants mais le sont par l'intermédiaire d'atténuateurs résistifs 28 symbolisés par des blocs. De tels atténuateurs comportent une connexion aux extrémités respectives 142 et 144 et aux plots 26 concernés (connexions symbolisées par des pointillés en figure 2) ainsi qu'une connexion à la masse.

Pour simplifier, un niveau conducteur a été illustré en figure 2 mais on notera qu'en pratique, l'ensemble du coupleur requiert généralement trois niveaux conducteurs.

Une fois réalisé sur le substrat isolant, l'ensemble est encapsulé dans un boîtier. La surface du circuit est, dans l'exemple de la figure 2, fortement dépendante de la taille des bossages conducteurs 26.

En outre, une fois rapporté sur une carte de circuit électronique, le coupleur se trouve le plus souvent à faible distance d'un plan de masse de cette carte. Cela influence les performances du coupleur et impose généralement de tenir compte de l'implantation finale dans le dimensionnement du coupleur, ce qui est peu commode.

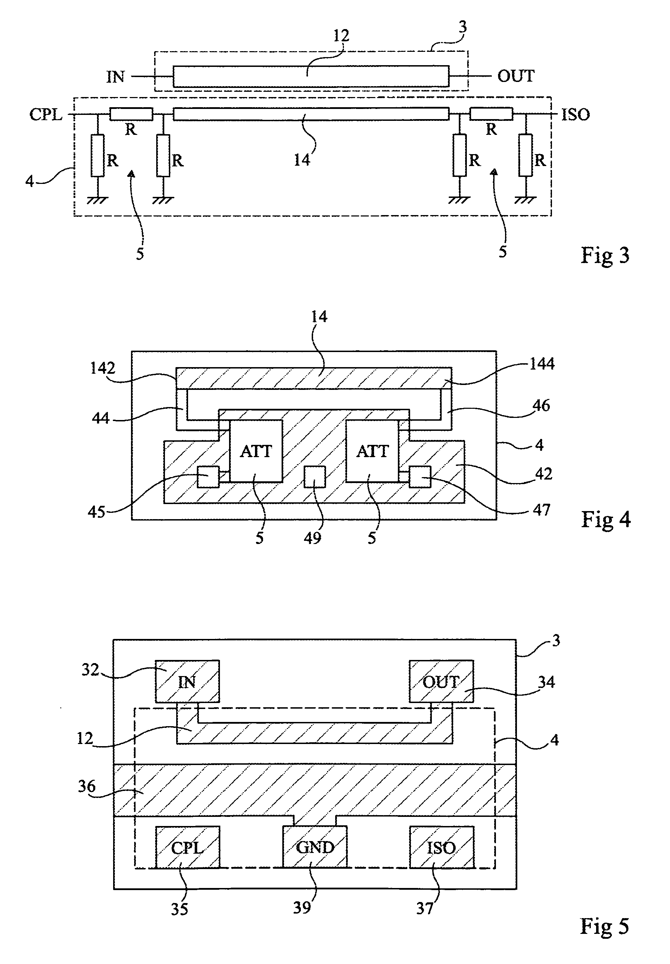

La figure 3 est une représentation très schématique d'un mode de réalisation d'un coupleur en boîtier.

Selon les modes de réalisation qui vont être décrits, on prévoit de réaliser la ligne secondaire 14 du coupleur sur un substrat isolant schématisé par un pointillé 4 et de réaliser la ligne principale 12 du coupleur au niveau du boîtier, symbolisé par un pointillé 3. L'inverse est également possible.

Dans l'exemple de la figure 3, les extrémités de la ligne 14 ne sont pas directement reliées aux bornes CPL et ISO mais le sont par l'intermédiaire d'atténuateurs résistifs 5. Ces atténuateurs sont en forme de pi (π) et comportent chacun trois résistances R. Une première de ces résistances relie l'extrémité de la ligne 14 respectivement à la borne CPL ou ISO, tandis que les deux autres résistances R de chaque atténuateur relient les extrémités de la première résistance de cet atténuateur à la masse.

La figure 4 est une vue de dessus schématique d'un mode de réalisation de la partie secondaire du coupleur sur un substrat isolant 4. Comme dans le mode de réalisation de la figure 2, plusieurs niveaux conducteurs sont utilisés pour réaliser les différents constituants. Dans l'exemple de la figure 4, la ligne secondaire est réalisée sous la forme d'une piste conductrice rectiligne 14 dans un premier niveau conducteur. Un plan de masse 42 est réalisé parallèlement à cette ligne 14 dans la surface du substrat 4. Les atténuateurs résistifs 5 sont formés à l'aplomb du plan de masse 42. Des pistes conductrices 44 et 46, non nécessairement dans le même niveau conducteur, relient les extrémités respectives 142 et 144 de la piste 14 à une première borne des atténuateurs respectifs. Une deuxième borne de ces atténuateurs est reliée à un plot conducteur 45 ou 47 définissant les bornes CPL et ISO. Une troisième borne des atténuateurs est connectée au plan de masse 42. Un plot 49 est destiné à ramener le contact du plan de masse jusqu'à l'extérieur du boîtier.

La taille du substrat isolant est réduite par rapport à une réalisation usuelle (figure 2), ne serait ce que par le fait qu'une seule des lignes couplées y est formée. De plus, seule une moitié des contacts a besoin d'être prévue au lieu des zones imposantes de réception des bossages.

La figure 5 est une vue de dessous du boîtier 3 selon ce mode de réalisation. La vue de la figure 5 est désignée arbitrairement de dessous. Il peut également s'agir d'une vue de dessus selon le sens dans lequel est placé le boîtier. Le boîtier inclut une piste conductrice 12 de formation de la ligne principale du coupleur. Les deux extrémités de cette piste sont reliées à des plots conducteurs 32 et 34 définissant les bornes IN et OUT du coupleur. La piste 12 est réalisée de façon à être approximativement à l'aplomb de la piste 14 (encombrement du substrat 4 illustré par un pointillé en figure 5).

Le couplage est donc désormais vertical au lieu d'horizontal.

De préférence, un plan de masse 36 est réalisé au niveau de la piste 12, approximativement à l'aplomb du plan de masse 42. Ce plan 36 est connecté à un plot de masse 39 également relié par un via au plot 49 du substrat 4. Enfin, des plots 35 et 37 conducteurs sont réalisés à l'aplomb des plots 45 et 47 pour en reprendre les contacts à l'extérieur du boîtier.

De préférence, les éléments conducteurs formés au niveau du boîtier sont définis dans une grille de connexion (lead frame) sur lequel est rapporté le substrat 4 lors de la mise en boîtier. L'emploi d'une telle grille avant encapsulation est généralement réservé à la réalisation d'un plan de masse et de zones de reprise de contact. Ici, on y forme également la piste 12.

Les inventeurs se sont aperçus qu'une meilleure directivité est obtenue quand des plans de masse sont en regard avec une forme la plus similaire possible dans les niveaux dans lesquels sont formées les lignes principale et secondaire. Dans le mode de réalisation des figures 4 et 5, le plan de masse 36 est symbolisé par une ligne. En variante, si le plan de masse s'étend autour de la ligne secondaire, un plan de masse similaire sera réalisé dans la grille de connexion.

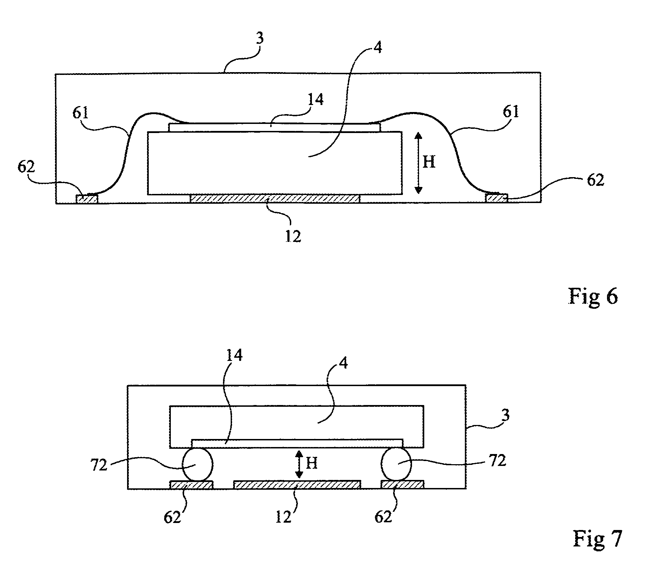

La figure 6 est une vue en coupe d'un premier mode de réalisation de la structure illustrée par les figures 3 à 5.

La représentation de la figure 6 est très schématique et illustre simplement les positions respectives des différents éléments dans l'épaisseur du boîtier 3. Dans cet exemple, on suppose que le substrat 4 est rapporté, par sa face arrière (opposée à celle sur laquelle est réalisée la piste 12), sur une grille de connexion. La grille de connexion comporte des zones 62 de réception de fils conducteurs 61 de report des contacts (45, 47, 49, figure 4) de la face supérieure du substrat 4. En face inférieure du boîtier 3, on retrouve la ligne principale 14. En pratique, une couche isolante est rapportée en face inférieure en ne laissant accessible que des contacts. Ce type de boîtier est, par exemple, destiné à être rapporté sur une carte de circuit imprimé (non représentée).

L'épaisseur H du substrat 4 entre les lignes 12 et 14 conditionne la directivité du coupleur et est choisie en fonction de l'impédance des lignes conductrices qui fixe l'adaptation d'impédance.

La figure 7 représente un autre mode de réalisation dans lequel le substrat 4 définit des zones de réception de bossages conducteurs 72. Le substrat 4 est alors rapporté sur la grille de connexion portant la ligne 12 et des zones de reprise de contact 62 avec sa face avant (portant la ligne 14) vers le bas. L'ensemble est ensuite encapsulé dans une résine pour former le boîtier 3. La hauteur H est conditionnée par l'épaisseur des bossages conducteurs.

A titre d'exemple particulier de réalisation, un écart H de quelques centaines de micromètres entre les lignes principale et secondaire fournit une bonne directivité.

Un avantage des modes de réalisation décrits est de tirer profit des écarts importants liés aux épaisseurs de fabrication d'un circuit électronique plutôt que d'accroître les écarts entre pistes dans le plan. On économise ainsi en surface du coupleur.

Divers modes de réalisation ont été décrits, diverses variantes et modifications apparaîtront à l'homme de l'art. En particulier, la réalisation pratique de l'invention est à la portée de l'homme du métier à partir des indications fonctionnelles données ci-dessus et de l'impédance souhaitée pour le coupleur. De plus, les dimensions des lignes conductrices et les valeurs à donner aux résistances sont également adaptables en fonction de l'application. En outre, d'autres structures de boîtier sont envisageables, pourvu que l'écart entre les lignes couplées soit obtenu dans l'épaisseur. Par exemple, on pourra superposer deux substrats portant chacun une des lignes (et un plan de masse).

## Revendications

1. Coupleur en lignes distribuées comportant une première ligne (12) destinée à véhiculer un signal radiofréquence entre ses deux extrémités et une deuxième ligne (14) destinée à prélever, par couplage, une partie dudit signal, dans lequel :
une des lignes est formée sur un substrat isolant (4) ; et **caractérisé en ce que**
l'autre ligne est formée dans une grille de connexion sur laquelle est rapportée le substrat, les deux lignes étant à l'aplomb l'une de l'autre.

2. Coupleur selon la revendication 1, dans lequel les extrémités de la deuxième ligne sont connectées à des atténuateurs résistifs (5).

3. Coupleur selon la revendication 1 ou 2, dans lequel des plans de masse (36, 42) sont réalisés approximativement à l'aplomb l'un de l'autre sur le substrat (4) et dans la grille de connexion.

4. Coupleur selon l'une quelconque des revendications 1 à 3, dans lequel la deuxième ligne (14) est réalisée sur une première face du substrat (4), rapporté par son autre face à l'aplomb de la ligne principale (12).

5. Coupleur selon l'une quelconque des revendications 1 à 3, dans lequel la deuxième ligne (14) est formée sur la première face du substrat (4), rapportée par l'intermédiaire de bossages conducteurs (72) sur la grille de connexion.

## Claims

1. A distributed coupler comprising a first line (12) intended to convey a radio signal between its two ends and a second line (14) intended to sample, by coupling, part of said signal, wherein:
one of the lines is formed on an insulating substrate (4); and **characterized in that**
the other line is formed in a lead frame supporting the substrate, one line being above the other.

2. The coupler of claim 1, wherein the ends of the second line are connected to resistive attenuators (5).

3. The coupler of claim 1 or 2, wherein ground planes (36, 42) are formed approximately above each other on the substrate (4) and in the lead frame.

4. The coupler of any of claims 1 to 3, wherein the second line (14) is formed on a first surface of the substrate (4), which has its other surface above the main line (12).

5. The coupler of any of claims 1 to 3, wherein the second line (14) is formed on a first surface of the substrate (4), placed via conductive bumps (72) on the lead frame.

## Patentansprüche

1. Ein verteilter Koppler, der eine erste Leitung (12) aufweist, die dafür vorgesehen ist ein Funksignal zwischen zwei Enden zu übermitteln und eine zweite Leitung (14), die dazu vorgesehen ist, Teile des Signals durch Koppeln zu Sampeln, wobei:
eine der Leitungen auf einem isolierenden Substrat (4) ausgebildet ist; **dadurch gekennzeichnet, dass**
die andere Leitung in einem Leitungsrahmen, der das Substrat trägt, ausgebildet ist, wobei eine Leitung über der anderen angeordnet ist.

2. Der Koppler nach Anspruch 1, wobei die Enden der zweiten Leitung mit Widerstandsdämpfungsgliedern (5) verbunden sind.

3. Der Koppler nach Anspruch 1 oder 2, wobei Grundplatten (36, 42) näherungsweise übereinander auf dem Substrat (4) und in dem Leitungsrahmen ausgebildet sind.

4. Der Koppler nach einem der Ansprüche 1 bis 3, wobei die zweite Leitung (14) auf einer ersten Oberfläche des Substrats (4) ausgebildet ist, die ihre andere Oberfläche über der Hauptleitung (12) hat.

5. Der Koppler nach einem der Ansprüche 1 bis 3, wobei die zweite Leitung (14) auf einer ersten Oberfläche des Substrats (4) ausgebildet ist, die über leitende Erhebungen (72) auf dem Leitungsrahmen angeordnet ist.
